# EUROPEAN PATENT APPLICATION

(11) **EP 1 202 455 A2**
(43) Date of publication of application: **02.05.2002**
(21) Application number: 01113271.9
(22) Date of filing: 31.05.2001
(51) Int. Cl.: H03H 9/58

(54) **A packaging methodology for duplexers using fbars**

(30) Priority: 31.10.2000 US 702499
(71) Applicant: Agilent Technologies, Inc. (a Delaware corporation), Palo Alto, CA 94303 (US)
(72) Inventor: Bradley, Paul, View, CA 94040 (US); Larson, John D., Palo Alto, CA 94301 (US); Ruby, Richard C., Menlo Park, CA 94025 (US)
(74) Representative: Schoppe, Fritz, Dipl.-Ing.

(57) **Abstract**

Film bulk acoustic resonators when used in electronic filters are prone to small shifts in resonant frequency as a result of inductances in the ground paths. These inductances can create undesirable electrical and/or physical characteristics that effect performance. The degradation can be minimized if the physical layout of the filter and package.

## Description

### Field of the Invention

The invention relates to electronic components and, in particular, to electronic components used in high-power radio-frequency circuits.

### BACKGROUND

In many different communications applications, a common signal path is coupled both to the input of a receiver and to the output of a transmitter. For example, in a transceiver, such as a cellular or cordless telephone, an antenna may be coupled to the input of the receiver and to the output of the transmitter. In such an arrangement, a duplexer is used to couple the common signal path to the input of the receiver and to the output of the transmitter. The duplexer provides the necessary coupling while preventing the modulated transmit signal generated by the transmitter from being coupled from the antenna back to the input of the receiver and overloading the receiver.

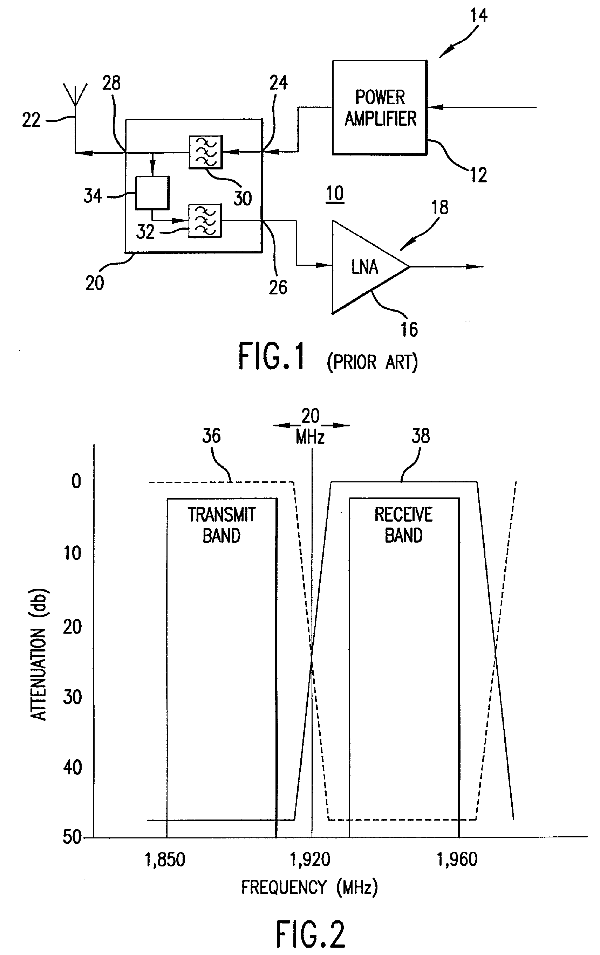

A typical duplexer is a three-port device having a transmit port, a receive port, and an antenna port. The antenna port is connected to the transmit port through the band-pass filter and to the receive port through the series arrangement of the 90° phase shifter and band-pass filter. The pass bands of the first and second band-pass filters are centered on the frequency range of the transmit signal generated by the transmitter and that of the receive signals to which the receiver can be tuned. In Figure 1 *(prior art duplexer),* the band-pass filters are configured such that the high-frequency stop band of the first band-pass filter overlaps the pass-band of the second band-pass filter and the low-frequency stop band of the second band-pass filter.

The requirements for the first and second band-pass filters are quite stringent. The band-pass filters isolate the very weak receive signal generated by the antenna and fed to the input of the low-noise amplifier from the strong transmit signal generated by the power amplifier. In a typical embodiment, the sensitivity of the low noise amplifier is about -100 dBm, and the power amplifier can feed power levels of about 28 dBm into the duplexer. In this situation, the duplexer must attenuate the transmit signal by about 50 dB between the antenna port and the receive port to prevent the residual transmit signal mixed with the receive signal at the receive port from overloading the low-noise amplifier.

This duplexer is used in the personal communication system (PCS) using Code Division Multiple Access (CDMA). CDMA-PCS devices operate in frequency bands at about 1.9 GHz and impose especially stringent requirements on the duplexer performance. The guard band between the portions of the spectrum assigned to the transmit signal and the receive signal is only about 1% of the carrier frequency, i.e. 20 MHz. The bandwidth of the portions of the spectrum assigned to the transmit signal and the receive signal are about 3% of the carrier frequency, i.e. 60 MHz. This means that the band-pass filters are required to have an extremely sharp roll-off. Figure 2 illustrates the basic arrangement of the transmit and receive bands.

When film bulk acoustic resonators (FBARs) are used in these high quality electronic filters, the performance is sensitive to small amounts of undesired coupling between connections between filter chip and the printed circuit board. These undesired couplings occur on the chip, in the wire-bonds connecting the package to the chip, and in the package itself. In the PCS duplexer, mutual inductances of approximately 1 picoHenry produce noticeable degradation of performance, particularly in the steep transition from pass-band to the reject-band just below pass-band.

### SUMMARY OF THE INVENTION

The present invention addresses the undesired coupling between the package and a filter chip using film bulk acoustic resonators (FBARs). The degradation can be minimized if the physical layout of the filter and package is considered.

A die that includes a film bulk acoustic resonator (FBAR) receive-band filter is positioned on a ceramic substrate including a ground plane through a die-attach paddle electrically connected to the ground plane. A victimizer and a victim loop of current are formed after packaging. The victimizer loop includes the input of the die and ceramic substrate. The victim loop includes the output of the die and ceramic substrate. During operation, the victimizer loop can induce parasitic current in the victim loop.

The parasitic current may be minimized in several ways. The wire bonds and bond-pads of the current carrying pins in the victimizer loop are positioned proximate to one another to minimize mutual inductance. In the victim loop, the wire-bond pads of the current carrying pins are connected to the die attach paddle. These wire-bond pads current carrying pins of both current loops are spaced apart. The area of the current loops are minimized and placed as far apart as possible in the package while maintaining connectivity for the chip. The interactions between the wirebonds of the pair of pins 1 and 3 and the pair of pins 2 and 4 should be perpendicular to each other.

### BRIEF DESCRIPTION OF THE DRAWINGS

Figure 1 illustrates a prior art PCS-duplexer.
Figure 2 illustrates the characteristics of the band-pass filters shown in Figure 1.
Figure 3 illustrates a schematic layout of a PCS duplexer.
Figure 4 illustrates a packaging assembly of the present invention for the PCS duplexer shown in Figure 3.

### DETAILED DESCRIPTION OF THE DRAWINGS

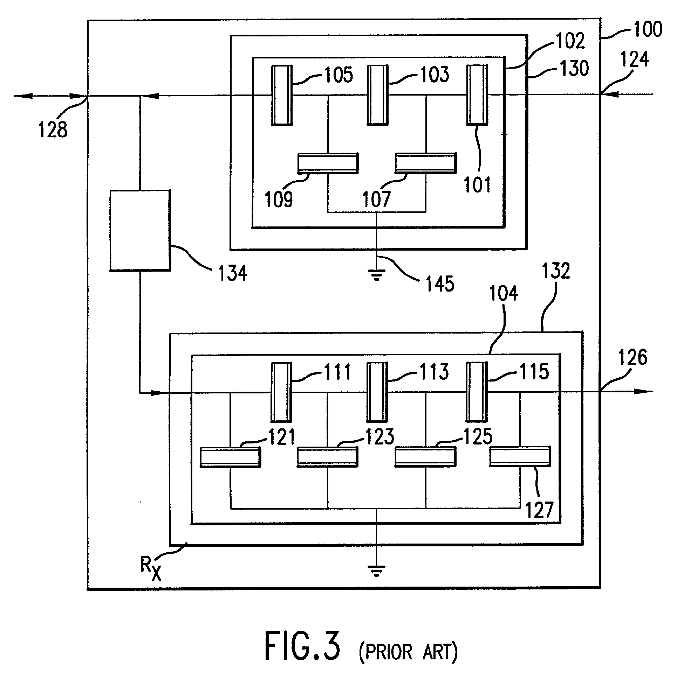

In pending application 09/324,618, "Duplexer Incorporating Thin-Film Bulk Acoustic Resonators", filed 2 June 1999, assigned to the assignee of this disclosure, film bulk acoustic resonators (FBARs) were described for use with a personal communication system (PCS) duplexer, shown in Figure 3. The duplexer uses a transmit FBAR array and a receive FBAR array. The duplexer includes a transmit port, a receive port, and an antenna port. The duplexer is composed of a 90° phase shifter, a transmit band-pass filter that includes the transmit FBAR array, and a receive band-pass filter that includes the receive FBAR array. The transmit port is connected to the antenna port through the transmit band-pass filter. The antenna port is connected to the receive port through the series arrangement of the 90° phase shifter and the receive band-pass filter.

The transmit band-pass filter is composed of an integrated transmit FBAR array. All the FBARs are manufactured on a common piezoelectric layer. The transmit FBAR array 102 is composed of a series of FBARs 101, 103, 105 and shunt FBARs 107, 109 connected to form a ladder circuit. The series FBARs are connected in series between the transmit port and the antenna port, the shunt FBAR 107 is connected between ground and the node between the series FBARs 101, 103 and the shunt FBAR 109 is connected between ground and the node between the series FBARs 103, 105. Figure 3 illustrates a 2 ½- stage ladder circuit. The transmit FBAR array may include any number of full stages, each composed of one series FBAR and one shunt FBAR. The number of ½ stages depends upon the desire filter characteristics of the transmit band-pass filter and the characteristics of the individual FBARS constituting the transmit FBAR array.

In a CDMA-PCS duplexer, the receive band-pass filter is required to attenuate the transmit signal at the antenna port to such a low level that the residual transmit signal mixed with the receive signal at the receive port does not overload the highly sensitive low noise amplifier of the receiver connected to the receive port. Consequently, the transmit signal rejection requirements of the receive band-pass filter are considerably more stringent that the receive signal rejections requirements of the transmit band-pass filter. To provide the desired filter characteristics for the receive band-pass filter, not all of the shunt FBARs in the receive FBAR array should have the same resonant frequency.

The receive band-pass filter is composed of an integrated receive FBAR array, the series auxiliary inductors 241, 243 and the shunt auxiliary inductors 231, 233, 235, and 237. All the FBARs are manufactured on a common piezoelectric layer. The receive FBAR array is composed of the series FBARs 211, 213, and 215 and the shunt FBARs 221, 223, 225, and 227 connected to form a ladder circuit. The series auxiliary inductor 241, the series FBARs, and the series auxiliary inductor are connected in series between the end of the 90° phase shifter remote from the antenna port and the receive port. The shunt FBAR 221 and the shunt auxiliary inductor 231 are connected in series between ground and the node between the series auxiliary inductor 241 and the series FBAR 211. The shunt FBAR 223 and the shunt auxiliary inductor 233 are connected in series between ground and the node between the series FBARS 211 and 213. The shunt FBAR 225 and the shunt auxiliary inductor 235 are connected in series between ground and the node between the series FBARs 213 and 215. The shunt FBAR 227 and the shunt auxiliary inductor 237 are connected in series between ground and the node between the series FBAR 215 and the series auxiliary inductor 243. Figure 5 illustrates a 3½ stage ladder circuit. The number of full stages and the number of half stages depends upon the desired filter characteristics of the receive band pass filter and the characteristics of the individual FBARs constituting the receive FBAR array.

Each auxiliary inductance has two main effects, mainly to slightly reduce the frequency of the series resonance of the corresponding FBAR, and to introduce an additional series resonance. The auxiliary inductance has a negligible effect on the frequency of the parallel resonance. Hence, each auxiliary inductor "tunes" the corresponding FBAR.

Unfortunately, the auxiliary inductors, particularly the shunt auxiliary inductors, not only effect the FBARS but each other particularly after packaging. A filter assembly includes a receive band filter chip having FBARs attached to a ceramic substrate through a die attach paddle. Wire-bonds extend from the chip to wire-bond pads positioned on the ceramic substrate. A die-attach paddle is electrically connected to a ground plane within the ceramic substrate.

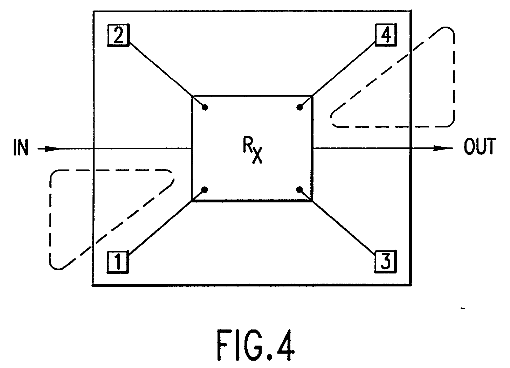

Within the mounted receiver Rₓ package, there are two induced current loops: victimizer and victim. The victimizer loop, shown as a dashed line in the 4 stage receive-band filter illustrated in Figure 4, carries a large amount of current from the filter chip input (pin 2) to ground. The victim loop, shown as a dotted line, preferably carries a small amount of current from the filter chip output (pin 3) to ground. The victim loop is susceptible to magnetic fields over time. The victimizer loop can induce parasitic current in the victim loop.

To minimize the parasitic current, the area of either current loop may be minimized. However, optimum results are achieved when the areas of both current loops are minimized. The current loops are placed as close as possible to the ground plane. As shown in Figure 4, the area of the victim and victimizer loops are minimized and the loops are placed as far apart as possible in the package. The wirebonds of the pair of pins 1 and 3 and the pair of pins 2 and 4 are perpendicular to each other for maximum isolation. In addition, the loops should be as far apart as possible to minimize coupling. For pin isolation, the distance between the "victim" pin and the victimizer pins should be maximized.

The parasitic current may be further controlled by the layout of the victimizer loop. The receiver band filter chip is preferably laid out such that the two shunts farthest apart in the filter are physically the farthest apart. Ideally, all the pins are far apart, but it is most critical that pins 1 and 4 are the farthest apart. Next in importance are pins 1 and 3 and pins 2 and 4. The remaining combinations are not as important.

As the mutual inductance between pins is roughly proportional to the square of the height of the chip, wire-bonds, and package pins to the grounded die-attach metal paddle, this height should be minimized. Furthermore, the ground inductance of the metal paddle should be minimized. The mutual inductance between the two leads connecting the chip to the PCB can be minimized when there is a short wire bond to the die-attach paddle.

## Claims

1. A filter assembly comprising:
a ceramic substrate including a ground plane;
a die including a film bulk acoustic resonator receive-band filter, positioned on the ceramic substrate, having an input and an output;
a die-attach paddle electrically connected to the ground plane;
a first and a second loop of current, the first loop including the input of the die and ceramic substrate, the second loop including the output of the die and ceramic substrate, wherein the first loop induce parasitic current in the second loop; and
two wire bonds in the first loop, electrically connecting the die to the ground connector, wherein the two wire bonds are positioned proximate to one another to minimize mutual inductance.

2. A filter assembly, as defined in claim 1, further comprising two wire bond pads in the first loop, interposing the respective wire bond and ceramic substrate, positioned proximate to one another to minimize mutual inductance.

3. A filter assembly, as defined in claim 1, further comprising a wire-bond and a wire-bond pad in the second loop, the wire-bond pad being connected to the die attach paddle.

4. A filter assembly, as defined in claim 3, wherein the wire-bond pad of the second loop is distal to the two wire-bond pads of the first loop.

5. A filter assembly, as defined in claim 3, wherein the first loop is perpendicular to the second loop.
